# EUROPEAN PATENT APPLICATION

(11) **EP 4 513 578 A1**
(43) Date of publication of application: **26.02.2025**
(21) Application number: 23791506.1
(22) Date of filing: 15.02.2023
(51) Int. Cl.: H01L 33/48, C09K 11/02, C09K 11/62, C09K 11/80, H01L 33/50, H01L 33/60

(54) **LIGHT-EMITTING DEVICE, SPECTROSCOPE, AND METHOD FOR PRODUCING LIGHT-EMITTING MEMBER**

(30) Priority: 21.04.2022 JP 2022070290; 24.06.2022 JP 2022101719; 26.01.2023 JP 2023010361
(71) Applicant: Nichia Corporation, Anan-shi, Tokushima 774-8601 (JP)
(72) Inventor: SANO, Yukiko, Anan-shi, Tokushima 774-8601 (JP); KIJIMA, Naoto, Anan-shi, Tokushima 774-8601 (JP); MURAZAKI, Yoshinori, Anan-shi, Tokushima 774-8601 (JP)
(74) Representative: Vossius & Partner Patentanwälte Rechtsanwälte mbB
(86) International application number: PCT/JP2023/005106
(87) International publication number: WO 2023/203850

(57) **Abstract**

A light-emitting device, a spectroscope, and a method for producing a light-emitting member are provided. A light-emitting device including: a light-emitting element configured to emit first light; a light-emitting member disposed on a light emission side of the light-emitting element and including a resin and a light-emitting material, the light-emitting material being configured to absorb the first light and configured to emit second light having an emission peak wavelength from 800 nm to 1100 nm; and an optical thin film disposed on a light emission side of the light-emitting member and configured to reflect the first light and transmit the second light. In an emission spectrum of the light-emitting device, a first integrated value ratio Ib/Ia that is an integrated value Ib of emission intensity at a wavelength in a range from 550 nm to 600 nm with resoect to an integrated value Ia of emission intensity at a wavelength in a range from 200 nm to less than 550 nm is in a range from 0 to 0.05, and a second integrated value ratio Ic/Ia that is an integrated value Ic of emission intensity at a wavelength in a range from 800 nm to 1100 nm with respect to the integrated value Ia is in a range from 0.75 to 30.

## Description

### Technical Field

The present disclosure relates to a light-emitting device, a spectroscope, and a method for producing a light-emitting member.

### Background Art

There is a case in which a light-emitting device using a light-emitting element of a light-emitting diode (LED) or a laser diode (LD) is required to be a light-emitting device that emits light in a wavelength range from red light to near-infrared light. A light-emitting device that emits light in a wavelength range from red light to near-infrared light is desired to be used for, for example, an infrared camera, infrared communication, plant growth, a light source for cultivation, vein authentication, which is one type of biometric authentication, a spectroscope that non-destructively measures the sugar content of food such as fruits and vegetables, and the like.

The light-emitting device is required to emit light in a desired wavelength range effectively using light emission from the light-emitting element. For example, Patent Document 1 discloses that a light-emitting element mounted on a base, a reflective member formed on the base and surrounding the light-emitting element, a transparent member having a flat upper surface and disposed covering the upper side of the light-emitting element, and a DBR film disposed on the upper surface of the transparent member are included, and the DBR film disposed on the upper surface of the transparent member reduces the transmittance for light perpendicular to an optical axis direction of light emitted from the light-emitting element.

### Citation List

### Patent Literature

Patent Document 1: JP 2019-096791 A

### Summary of Invention

### Technical Problem

An object of the present disclosure is to provide a light-emitting device and a spectroscope both of which can increase emission intensity of light in a wavelength range from red light to near-infrared light, and a method for producing such a light-emitting member.

### Solution to Problem

A first aspect is a light-emitting device including: a light-emitting element configured to emit first light having an emission peak wavelength in a range from 200 nm to 550 nm; a light-emitting member including a resin and a light-emitting material configured to emit second light having an emission peak wavelength in a range from 780 nm to 1100 nm, the light-emitting material being disposed on a light emission side of the light-emitting element and configured to absorb and emit at least part of the first light; and an optical thin film disposed on a light emission side of the light-emitting member and configured to reflect the first light and transmit the second light, in which in an emission spectrum of a light-emitting device, a first integrated value ratio Ib/Ia that is an integrated value Ib of emission intensity at a wavelength in a range from 550 nm to 600 nm to an integrated value Ia of emission intensity at a wavelength in a range from 200 nm to less than 550 nm is in a range from 0 to 0.05, and a second integrated value ratio Ic/Ia that is an integrated value Ic of emission intensity at a wavelength in a range from 800 nm to 1100 nm to the integrated value Ia is in a range from 0.75 to 30.

A second aspect is a light-emitting device including: a light-emitting element configured to emit first light having an emission peak wavelength in a range from 200 nm to 550 nm; and a light-emitting member including a resin and a light-emitting material configured to emit second light having an emission peak wavelength in a range from 780 nm to 1100 nm, the light-emitting material being disposed on a light emission side of the light-emitting element and configured to absorb and emit at least part of the first light, the light-emitting member including the light-emitting material in a range from 250 parts by mass to 500 parts by mass with respect to 100 parts by mass of the resin, in which in an emission spectrum of the light-emitting device, a first integrated value ratio Ib/Ia of an integrated value Ib of emission intensity at a wavelength in a range from 550 nm to 600 nm to an integrated value Ia of emission intensity at a wavelength in a range from 200 nm to less than 550 nm is in a range from 0 to 0.05, and a second integrated value ratio Ic/Ia that is an integrated value Ic of emission intensity at a wavelength in a range from 800 nm to 1100 nm to the integrated value Ia is in a range from 0.75 to 30.

A third aspect is a light-emitting device including: a light-emitting element configured to emit first light having an emission peak wavelength in a range from 200 nm to 550 nm; and a light-emitting member including a resin and a light-emitting material configured to emit second light having an emission peak wavelength in a range from 780 nm to 1100 nm, the light-emitting material being disposed on a light emission side of the light-emitting element and configured to absorb and emit at least part of the first light, in which a third integrated value ratio Ic/Ia' that is an integrated value Ic of emission intensity at a wavelength in a range from 800 nm to 1100 nm in an emission spectrum of the light-emitting device to an integrated value Ia' of emission intensity at a wavelength in a range from 200 nm to less than 550 nm in an emission spectrum of the light-emitting element is 0.13 or more.

A fourth aspect is a spectroscope including the light-emitting device.

A fifth aspect is a method for producing a light-emitting member, including: mixing a resin, a solvent having a boiling point in a range from 140°C to 300°C, and a light-emitting material that absorbs at least part of first light having an emission peak wavelength in a range from 200 nm to 550 nm and emits second light having an emission peak wavelength in a range from 800 nm to 1100 nm to prepare a light-emitting member composition including the light-emitting material in a range from 250 parts by mass to 500 parts by mass with respect to 100 parts by mass of the resin; and curing the light-emitting member composition to form a light-emitting member.

### Advantageous Effects of Invention

According to the present disclosure, it is possible to provide a light-emitting device and a spectroscope both of which can increase emission intensity of light in a wavelength range from red light to near-infrared light, and a method for producing such a light-emitting member.

### Brief Description of Drawings

FIG. 1 is a schematic cross-sectional view illustrating an example of the light-emitting device of the first aspect or the third aspect.
FIG. 2 is a schematic perspective view illustrating an example of the light-emitting device of the first aspect or the third aspect.
FIG. 3 is a schematic cross-sectional view illustrating an example of the light-emitting device of the second aspect or the third aspect.
FIG. 4 is a graph showing a transmission spectrum of a dielectric multilayer film that is an optical thin film.
FIG. 5 is a graph showing emission spectra of the light-emitting devices according to Example 2 and Comparative Examples 1 and 2.
FIG. 6 is a graph showing an emission spectrum of the light-emitting element used in Examples.

### Description of Embodiments

Hereinafter, a light-emitting device, a spectroscope, and a method for producing such a light-emitting member according to the present disclosure will be described. However, the following embodiment is an example for embodying the technical idea of the present invention, and the present invention is not limited to the following light-emitting device, spectroscope, and method for producing a light-emitting member. Note that regarding visible light, a relationship between a color name and chromaticity coordinates, a relationship between a wavelength range of light and a color name of monochromatic light, and the like, for example, a wavelength range of red light conform to JIS Z8110. In the present specification, the terms "up/upper/upward" and "down/lower/downward" may also be used as terms that mean a light extraction side and the opposite side thereto in the light-emitting device. For example, "upward" means a direction in which light is extracted, and "downward" means the opposite direction. Furthermore, "upper surface" means a surface on a light extraction side, and "lower surface" means a surface on the opposite side. Furthermore, a lateral surface refers to a surface in a direction orthogonal to the upper surface or the lower surface. In the present specification, a full width at half maximum refers to a wavelength width at which the emission intensity is 50% of the emission intensity at the emission peak wavelength indicating the maximum emission intensity at a wavelength in the emission spectrum.

A light-emitting device of the first aspect includes: a light-emitting element configured to emit first light having an emission peak wavelength in a range from 200 nm to 550 nm;
a light-emitting member comprising a resin and a light-emitting material disposed on a light emission side of the light-emitting element and configured to absorb and emit at least part of the first light, the light-emitting material being configured to emit second light having an emission peak wavelength in a range from 780 nm to 1100 nm; and an optical thin film disposed on a light emission side of the light-emitting member and configured to reflect the first light and transmit the second light, wherein in an emission spectrum of a light-emitting device, a first integrated value ratio Ib/Ia of an integrated value Ib of emission intensity at a wavelength in a range from 550 nm to 600 nm with respect to an integrated value Ia of emission intensity at a wavelength in a range from 200 nm to less than 550 nm is in a range from 0 to 0.05, and a second integrated value ratio Ic/Ia that is an integrated value Ic of emission intensity at a wavelength in a range from 800 nm to 1100 nm with respect to the integrated value Ia is in a range from 0.75 to 30.

The light-emitting member may contain the light-emitting material in a range from 100 parts by mass to 300 parts by mass with respect to 100 parts by mass of the resin. The light-emitting material that emits second light may have an emission peak wavelength in a range from 800 nm to 1100 nm. In the light-emitting device, a third integrated value ratio Ic/Ia' that is an integrated value Ic of emission intensity at a wavelength in a range from 800 nm to 1100 nm in the emission spectrum of the light-emitting device to an integrated value Ia' of emission intensity at a wavelength in a range from 200 nm to less than 550 nm in an emission spectrum of the light-emitting element is preferably 0.13 or more.

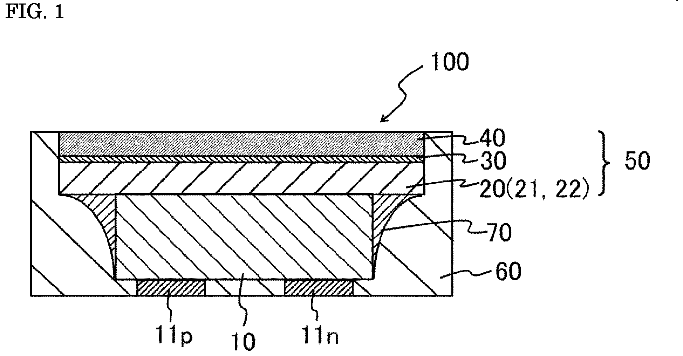

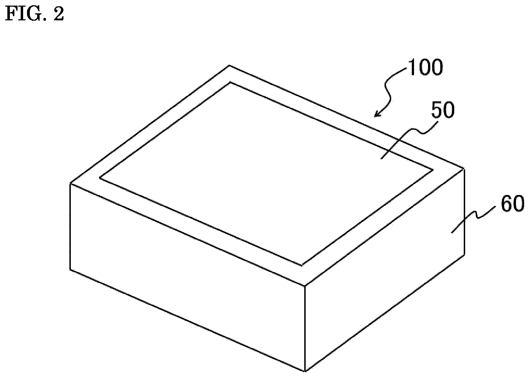

The light-emitting device will be described with reference to the drawings. FIG. 1 is a schematic cross-sectional view illustrating an example of the light-emitting device of the first aspect. FIG. 2 is a schematic perspective view of an example of the light-emitting device of the first aspect. For convenience of description, sizes, thicknesses, and the like of the light-emitting device and each member are merely examples and exaggerated. For the sake of description, scales of FIGS. 1 and 2, as well as FIG. 3 described later, are different from one another.

A light-emitting device 100 includes a light-emitting element 10 that emits first light having an emission peak wavelength in a range from 200 nm to 550 nm; a light-emitting member 20 including a resin 22 and a light-emitting material 21 that is disposed on a light emission side of the light-emitting element 10 and configured to absorb at least part of the first light and emit second light having an emission peak wavelength in a range from 780 nm to 1100 nm ; and an optical thin film 30 that is disposed on a light emission side of the light-emitting member 20, reflects the first light, and transmits the second light.

The light-emitting device 100 includes a light-transmissive member 40 on the emission side from which the second light exits. The light-transmissive member 40 preferably has a flat plate shape, and includes the optical thin film 30 on an incident side of the second light emitted from the light-emitting member 20. The light-transmissive member 40 may include the optical thin film 30 on the emission side of the second light of the light-transmissive member 40. The light-emitting member 20, the optical thin film 30, and the light-transmissive member 40 may constitute a wavelength conversion member 50. The light-emitting member 20 includes the light-emitting material 21 and the resin 22. The light-emitting device 100 includes a covering member 60 that covers the peripheries of the light-emitting element 10 and the wavelength conversion member 50. A light-transmissive bonding member 70 in contact with a lateral surface of the light-emitting element 10 and a part of the light-emitting member 20 is provided between the light-emitting element 10 and the covering member 60. The light-transmissive bonding member 70 can be an adhesive that bonds the light-emitting element 10 and the light-emitting member 20. The covering member 60 is disposed covering a lower surface of the light-emitting element 10, an electrode 11p, an electrode 11n, a lateral surface of the light-transmissive bonding member 70, and a lateral surface of the wavelength conversion member 50. The covering member 60 has light reflectivity and directly or indirectly covers the lateral surface of the light-emitting element 10. An outer lateral surface of the covering member 60 constitutes a lateral surface of the light-emitting device 100. The covering member 60 covers the light-emitting element 10 such that at least a part of each of the pair of electrodes 11p and 11n of the light-emitting element 10 is exposed. A lower surface of the covering member 60 constitutes a part of a lower surface of the light-emitting device 100. For details of the light-emitting device and the producing method therefor, for example, the disclosure of JP 2019-9429 A can also be referred to.

As illustrated in FIGS. 1 and 2, the light-emitting device 100 may have a substantially cuboid external shape. The light-emitting device may be a package having substantially the same size as the light-emitting element, a so-called chip scale package (CSP), or a planar light-emitting device in which a plurality of light-emitting elements are mounted at high density.

A light-emitting device of the second aspect includes: a light-emitting element configured to emit first light having an emission peak wavelength in a range from 200 nm to 550 nm; and a light-emitting member including a resin and a light-emitting material that is disposed on a light emission side of the light-emitting element and configured to absorb at least part of the first light and to emit second light having an emission peak wavelength in a range from 780 nm to 1100 nm. The light-emitting member contains the light-emitting material in a range from 250 parts by mass to 500 parts by mass with respect to 100 parts by mass of the resin. In an emission spectrum of the light-emitting device, a first integrated value ratio Ib/Ia that is an integrated value Ib of emission intensity at a wavelength in a range from 550 nm to 600 nm with respect to an integrated value Ia of emission intensity at a wavelength in a range from 200 nm to less than 550 nm is in a range from 0 to 0.05, Also, a second integrated value ratio Ic/Ia that is an integrated value Ic of emission intensity at a wavelength in a range from 800 nm to 1100 nm with respect to the integrated value Ia is in a range from 0.75 to 30. The light-emitting material that emits second light may have an emission peak wavelength in a range from 800 nm to 1100 nm. In the light-emitting device, a third integrated value ratio Ic/Ia' that is an integrated value Ic of emission intensity at a wavelength in a range from 800 nm to 1100 nm in the emission spectrum of the light-emitting device with respect to an integrated value Ia' of emission intensity at a wavelength in a range from 200 nm to less than 550 nm in an emission spectrum of the light-emitting element is preferably 0.13 or more.

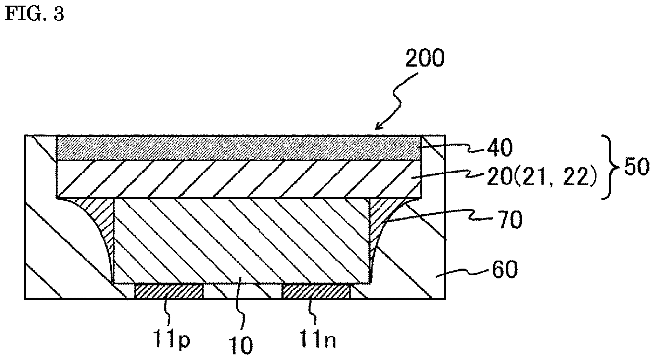

FIG. 3 is a schematic cross-sectional view illustrating an example of the light-emitting device of the second aspect.

A light-emitting device 200 may have a substantially cuboid external shape. The light-emitting device 200 may be a so-called CSP.

The light-emitting device 200 is different from the light-emitting device 100 of the first aspect illustrated in FIG. 1 in not including the optical thin film 30, and other configurations of the light-emitting device 200 are the same as or similar to those of the light-emitting device 100 of the first aspect. In the light-emitting device 200, members same as or similar to those of the light-emitting device 100 of the first aspect are given similar reference characters.

A light-emitting device of the third aspect includes: a light-emitting element configured to emit first light having an emission peak wavelength in a range from 200 nm to 550 nm; and a light-emitting member including a resin and a light-emitting material that is disposed on an emission side of the light-emitting element and configured to absorb at least part of the first light and configured to emit second light having an emission peak wavelength in a range from 780 nm to 1100 nm. A third integrated value ratio Ic/Ia' that is an integrated value Ic being emission intensity at a wavelength in a range from 800 nm to 1100 nm in an emission spectrum of the light-emitting device with respect to an integrated value Ia' of emission intensity at a wavelength in a range from 200 nm to less than 550 nm in an emission spectrum of the light-emitting element is 0.13 or more. Similarly to the light-emitting device of the first aspect, the light-emitting device of the third aspect may include an optical thin film that is disposed on the light emission side of the light-emitting member, reflects the first light, and transmits the second light, and may have a form same as or similar to that of the light-emitting device of the first aspect illustrated in FIGS. 1 and 2. The light-emitting material that emits second light may have an emission peak wavelength in a range from 800 nm to 1100 nm. Similarly to the light-emitting device of the second aspect, the light-emitting device of the third aspect does not include an optical thin film and may include a light-emitting member containing a light-emitting material in a range from 250 parts by mass to 500 parts by mass with respect to 100 parts by mass of a resin, and may have a form same as or similar to that of the light-emitting device of the second aspect illustrated in FIG. 3.

In the light-emitting device, in an emission spectrum of the light-emitting device, the first integrated value ratio Ib/Ia that is the integrated value Ib of the emission intensity at a wavelength in a range from 550 nm to 600 nm with respect to the integrated value Ia of the emission intensity at a wavelength in a range from 200 nm to less than 550 nm is in a range from 0 to 0.05. Also, the second integrated value ratio Ic/Ia that is the integrated value Ic of the emission intensity at a wavelength in a range from 800 nm to 1100 nm with respect to the integrated value Ia is in a range from 0.75 to 30. In the light-emitting device, when the first integrated value ratio Ib/Ia is in a range from 0 to 0.05 in the emission spectrum of the light-emitting device, a component of light with a wavelength in a range from 200 nm to less than 550 nm emitted to the outside of the light-emitting device is small with respect to a component of light with a wavelength in a range from 550 nm to 600 nm, and the first light emitted from the light-emitting element is effectively used in the light-emitting device and the wavelength is converted by the light-emitting material. When the second integrated value ratio Ic/Ia is in a range of 0.75 to 30 in the emission spectrum of the light-emitting device, the light-emitting device emits the second light having high emission intensity at a wavelength in a range from 800 nm to 1100 nm with respect to the first light emitted from the light-emitting element. In the light-emitting device, in the emission spectrum of the light-emitting device, the first integrated value ratio Ib/Ia may be in a range from 0.001 to 0.03, or may be in a range from 0.001 to 0.01. In the light-emitting device, in the emission spectrum, the second integrated value ratio Ic/Ia may be in a range from 0.75 to 20, may be in a range from 1.00 to 15, may be in a range from 1.20 to 10, and may be in a range from 2.00 to 6.00.

In the light-emitting device, a third integrated value ratio Ic/Ia' that is an integrated value Ic of emission intensity at a wavelength in a range from 800 nm to 1100 nm in an emission spectrum of the light-emitting device with respect to an integrated value Ia' of emission intensity at a wavelength in a range from 200 nm to less than 550 nm in an emission spectrum of the light-emitting element is 0.13 or more. In the light-emitting device, the third integrated value ratio Ic/Ia' may be 0.3 or less, may be 0.25 or less, may be 0.2 or less, may be 0.131 or more, may be 0.132 or more, and may be 0.133 or more. In the light-emitting device, in the spectrum of the light-emitting element, the emission intensity Ic of the second light with a wavelength in a range from 800 nm to 1100 nm is relatively high with respect to the integrated value Ia' of the emission intensity at a wavelength in a range from 200 nm to less than 550 nm, and the emission intensity can be increased in the wavelength range of red light to near-infrared light in the emission spectrum of the light-emitting device with respect to the emission spectrum of the light-emitting element. Thus, the light-emitting device can be used for a spectroscope and an analytical instrument, which are described later, and the like.

The light-emitting device can emit light in a range called a "biological window" because the wavelength of the first light emitted from the light-emitting element is converted by the light-emitting material and the second light with high emission intensity in a wavelength range from 800 nm to 1100 nm is emitted. The light-emitting device can measure an increase or decrease in absorption of light of hemoglobin combined with oxygen in blood, and the like, and can be used for an analytical instrument that obtains information in a living body, for example, vein authentication, which is one type of biometric authentication. The light-emitting device of the CSP can be mounted on a small mobile device such as a smartphone, and can be used for physical condition management and the like when information in a living body is obtained.

The light-emitting device can also be used for a spectroscope and a sugar content meter used for near-infrared spectroscopy used as a method for non-destructively measuring internal quality such as sugar content, acidity, ripeness, and internal damage of fruits and vegetables, and superficial layer quality appearing on a skin surface of fruits and vegetables such as abnormal drying or a skin superficial layer near the skin surface. The light-emitting device can be used for detection devices for an increase of meat such as mutton, pork, and offal, improper additives of ground meat, falsification of fish, quality inspection of chicken, and the like. As such a spectroscope, a light source such as a tungsten lamp or a xenon lamp has been used, but use of a light-emitting device such as a CSP as a light source can further downsize the spectroscope.

The light-emitting element that emits the first light has an emission peak wavelength in a range from 200 nm to 550 nm, and for example, an LED chip or an LD chip using a nitride-based semiconductor can be used as the light-emitting element.

The light-emitting element has an emission peak wavelength in a range from 200 nm to 550 nm, preferably has an emission peak wavelength in a range from 250 nm to 550 nm, more preferably has an emission peak wavelength in a range from 300 nm to 550 nm, and still more preferably has an emission peak wavelength in a range from 350 nm to 550 nm. The range of the emission peak wavelength of the light-emitting element is appropriately selected depending on the light-emitting material to be used such that the light-emitting material can efficiently emit light. The light-emitting material absorbs the first light emitted from the light-emitting element, and the light-emitting member can emit light with a wavelength in a range from 600 nm to 2500 nm. The light-emitting member more preferably emits light with a wavelength in a range from 600 nm to 1700 nm, and still more preferably emits light with a wavelength in a range from 600 nm to 1100 nm. The full width at half maximum of the light emission peak in the light emission spectrum of the light-emitting element may be, for example, 30 nm or less. As the light-emitting element, for example, a light-emitting element that uses a nitride-based semiconductor is preferably used. A stable light-emitting device that exhibits high efficiency and high linearity in its output with respect to the input and that is strong against mechanical impact can be obtained by using, as a light source, a light-emitting element in which a nitride-based semiconductor is used.

The light-emitting member included in the light-emitting device includes the light-emitting material and the resin. The light-emitting member may be formed having a flat plate shape, and may have a form having a lower surface, an upper surface, and a lateral surface.

The light-emitting material included in the light-emitting member preferably includes a phosphor. The phosphor preferably includes an oxide phosphor having a composition included in a composition formula represented by the following formula (I). The oxide phosphor having the composition included in the composition formula represented by the following formula (I) is also called a first oxide phosphor.

(Mg₁ - ₜ₁M¹ₜ₁)ᵤ₁(Ga_{1 - v1 - x1 - y1}M²ᵥ₁)₂O_{w1}:Crₓ₁, M³_{y1} (I)

(In the formula (I), M¹ is at least one element selected from the group consisting of Ca, Sr, Ba, Ni, and Zn, M² is at least one element selected from the group consisting of B, Al, In, and Sc, M³ is at least one element selected from the group consisting of Eu, Ce, Tb, Pr, Nd, Sm, Yb, Ho, Er, Tm, and Mn, and t1, u1, v1, w1, x1, and y1 satisfy 0 ≤ t1 ≤ 0.8, 0.7 ≤ u1 ≤ 1.3, 0 ≤ v1 ≤ 0.8, 3.7 ≤ w1 ≤ 4.3, 0.02 < x1 ≤ 0.3, 0 ≤ y1 ≤ 0.2, and y1 < x1.) In the present specification, in the composition formula representing the composition of the phosphor, the part before the colon (:) represents elements constituting a host crystal and the molar ratio thereof, and the part after the colon (:) represents activation elements. In the present specification, a plurality of elements separated by commas (,) in a formula representing the composition of the phosphor may mean that at least one element among the plurality of elements is included in the composition and may mean that a combination of two or more among the plurality of elements is included.

The phosphor may include a second oxide phosphor having a composition included in the composition formula represented by the following formula (II).

(Ga_{1-y2}M⁴_{y2})₂∘₃:Crₓ₂ (II)

(In Formula (II), M⁴ is at least one element selected from Al, Sc, and In, and x2 and y2 satisfy 0.001 ≤ x2 ≤ 0.3 and 0 ≤ y2 ≤ 0.5.)

The phosphor may include at least one oxide phosphor selected from the group consisting of a third oxide phosphor having a composition included in the composition formula represented by the following formula (III), a fourth oxide phosphor having a composition included in the composition formula represented by the following formula (IV), and a fifth oxide phosphor having a composition included in the composition formula represented by the following formula (V).

m⁵ₜ₃M⁶ᵤ₃M⁷ᵥ₃M⁸₅O_{w3}:Crₓ₃, M⁹_{y3} (III)

(In the formula (III), M⁵ is at least one element selected from the group consisting of Li, Na, K, Rb, and Cs, M⁶ is at least one element selected from the group consisting of Mg, Ca, Sr, Ba, and Zn, M⁷ is at least one element selected from the group consisting of B, Al, Ga, In, and a rare earth element, M⁸ is at least one element selected from the group consisting of Si, Ti, Ge, Zr, Sn, Hf, and Pb, M⁹ is at least one element selected from the group consisting of Eu, Ce, Tb, Pr, Nd, Sm, Yb, Ho, Er, Tm, Ni, and Mn, and t3, u3, v3, w3, x3, and y3 satisfy 0.7 ≤ t3 ≤ 1.3, 1.5 ≤ u3 ≤ 2.5, 0.7 ≤ v3 ≤ 1.3, 12.9 ≤ w3 ≤ 15.1, 0 < x3 ≤ 0.2, 0 ≤ y3 ≤ 0.10, and y3 < x3.)

M¹⁰ₜ₄M¹¹ᵤ₄(Ge_{1 - v4}M¹²ᵥ₄)₆O_{w4}:Crₓ₄, M¹³_{y4} (IV)

(In the formula (IV), M¹⁰ is at least one element selected from the group consisting of Li, Na, K, Rb, and Cs, M¹¹ is at least one element selected from the group consisting of Ca, Sr, Mg, Ba, and Zn, M¹² is at least one element selected from the group consisting of Si, Ti, Zr, Sn, Hf, and Pb, M¹³ is at least one element selected from the group consisting of Eu, Ce, Tb, Pr, Nd, Sm, Yb, Ho, Er, Tm, Ni, and Mn, and t4, u4, v4, w4, x4, and y4 satisfy 1.5 ≤ t4 ≤ 2.5, 0.7 ≤ u4 ≤ 1.3, 0 ≤ v4 ≤ 0.4, 12.9 ≤ w4 ≤ 15.1, 0 < x4 ≤ 0.2, 0 ≤ y4 ≤ 0.10, and y4 < x4.)

(Li_{1 - t5}M¹⁴ ₜ₅)ᵤ₅(Ga_{1 - v5}M¹⁵₅)₅O_{w5}:Crₓ₅, Ni_{y5}, M¹⁶_{z5} (V)

(In Formula (V), M¹⁴ is at least one element selected from the group consisting of Na, K, Rb, and Cs, M¹⁵ is at least one element selected from the group consisting of B, Al, Sc, In, and a rare earth element, M¹⁶ is at least one element selected from the group consisting of Si, Ge, Sn, Ti, Zr, Hf, Bi, V, Nb, and Ta, and t5, u5, v5, w5, x5, y5, and z5 satisfy 0 ≤ t5 ≤ 1.0, 0.7 ≤ u5 ≤ 1.6, 0 ≤ v5 < 1.0, 7.85 ≤ w5 ≤ 11.5, 0.05 ≤ x5 ≤ 1.2, 0 ≤ y5 ≤ 0.5, 0.05 ≤ x5 + y5 ≤ 1.2, y5 ≤ x5, and 0 ≤ z5 ≤ 0.5.)

When the light-emitting member includes a phosphor as a light-emitting material, the light-emitting member preferably includes at least the first oxide phosphor having the composition included in the composition formula represented by the formula (I). In addition to the first oxide phosphor, the phosphor may include at least one oxide phosphor selected from the group consisting of the second oxide phosphor, the third oxide phosphor, the fourth oxide phosphor, and the fifth oxide phosphor.

The light-emitting material included in the light-emitting member may be a quantum dot (QD) being a semiconductor nanoparticle that absorbs at least part of the first light emitted from the light-emitting element and emits the second light having an emission peak wavelength in a range from 780 nm to 1100 nm. When the light-emitting material is a quantum dot, the quantum dot may be included in a range from 0.1 mass% to 5 mass% with respect to the total amount of the light-emitting member. Examples of the quantum dot having a chalcopyrite structure include those having a composition included in the composition formula represented by (Ag,Cu,Au)(Al,Ga,In,Tl)(S,Se,Te)₂. One example of the quantum dot having a chalcopyrite structure is a quantum dot represented by AlInS₂. Specifically, the quantum dot disclosed in JP 2017-25201 A can also be used as a light-emitting material.

The resin included in the light-emitting member preferably includes at least one selected from the group consisting of an epoxy resin, a silicone resin, a phenol resin, and a polyimide resin.

The light-emitting member included in the light-emitting device of the first aspect or the light-emitting device of the third aspect preferably includes the light-emitting material in a range from 100 parts by mass to 300 parts by mass with respect to 100 parts by mass of the resin. In the light-emitting device of the first aspect including the light-emitting material in a range from 100 parts by mass to 300 parts by mass with respect to 100 parts by mass of the resin, the first light emitted from the light-emitting element is reflected by the optical thin film, at least part of the first light is absorbed by the light-emitting material and effectively used, and the second light is emitted from the light-emitting member. The light-emitting device of the first aspect or the light-emitting device of the third aspect including the light-emitting material in a range from 100 parts by mass to 300 parts by mass with respect to 100 parts by mass of the resin can emit light in which the first integrated value ratio Ib/Ia is in a range from 0 to 0.05 and the second integrated value ratio Ic/Ia is in a range from 0.75 to 30. Furthermore, the light-emitting device of the third aspect including the light-emitting material in a range from 100 parts by mass to 300 parts by mass with respect to 100 parts by mass of the resin can emit light in which the third integrated value ratio Ic/Ia' is 0.13 or more. The light-emitting member included in the light-emitting device of the first aspect or the light-emitting device of the third aspect more preferably includes the light-emitting material in a range from 150 parts by mass to 300 parts by mass with respect to 100 parts by mass of the resin, and still more preferably includes the light-emitting material in a range from 200 parts by mass to 250 parts by mass with respect to 100 parts by mass of the resin.

The light-emitting member included in the light-emitting device of the second aspect or the light-emitting device of the third aspect includes the light-emitting material in a range from 250 parts by mass to 500 parts by mass with respect to 100 parts by mass of the resin. In the light-emitting device of the second aspect or the light-emitting device of the third aspect including the light-emitting material in a range from 250 parts by mass to 500 parts by mass with respect to 100 parts by mass of the resin, even when the light-emitting device does not include the optical thin film that reflects the first light emitted from the light-emitting element, at least part of the first light is absorbed by the light-emitting material and effectively used, and the second light is emitted from the light-emitting member. In the light-emitting device of the second aspect or the light-emitting device of the third aspect including the light-emitting material in a range from 250 parts by mass to 500 parts by mass with respect to 100 parts by mass of the resin, light in which the first integrated value ratio Ib/Ia is in a range from 0 to 0.05 and the second integrated value ratio Ic/Ia is in a range from 0.75 to 30 is emitted from the light-emitting device. Furthermore, the light-emitting device of the third aspect including the light-emitting material in a range from 100 parts by mass to 300 parts by mass with respect to 100 parts by mass of the resin can emit light in which the third integrated value ratio Ic/Ia' is 0.13 or more. The light-emitting member included in the light-emitting device of the second aspect or the light-emitting device of the third aspect preferably includes the light-emitting material in a range from 300 parts by mass to 500 parts by mass with respect to 100 parts by mass of the resin, and more preferably includes the light-emitting material in a range from 350 parts by mass to 500 parts by mass with respect to 100 parts by mass of the resin.

The light-emitting member included in the light-emitting device of the second aspect or the light-emitting device of the third aspect preferably includes a scattering agent in a range from 1.0 mass% to 5.0 mass% with respect to the total amount of the light-emitting member. When the light-emitting member includes the scattering agent in a range from 1.0 mass% to 5.0 mass% with respect to the total amount of the light-emitting member, even when the light-emitting device does not include the optical thin film that reflects the first light emitted from the light-emitting element, the first light emitted from the light-emitting element is scattered by the scattering agent in the light-emitting member, the light-emitting material absorbs and effectively uses the first light, and the second light is emitted from the light-emitting member. The light-emitting member included in the light-emitting device of the second aspect or the light-emitting device of the third aspect preferably includes the scattering agent in a range from 1.0 mass% to 3.0 mass% with respect to the total amount of the light-emitting member, and more preferably includes the scattering agent in a range from 1.0 mass% to 2.0 mass% with respect to the total amount of the light-emitting member.

As the scattering agent, at least one selected from aluminum oxide, titanium oxide, yttrium phosphate, calcium carbonate, barium sulfate, silicone fine particles, acrylic fine particles, boron nitride, aluminum nitride, and calcium phosphate can be mixed and used. In particular, the scattering agent preferably includes at least one selected from the group consisting of aluminum oxide, titanium oxide, and yttrium phosphate.

The light-emitting device of the first aspect includes, on the light emission side of the light-emitting member, the optical thin film that reflects the first light emitted from the light-emitting element and transmits the second light emitted from the light-emitting member.

The light-emitting device of the second aspect or the light-emitting device of the third aspect may include, on the light emission side of the light-emitting member, the optical thin film that reflects the first light emitted from the light-emitting element and transmits the second light.

The optical thin film that reflects the first light preferably has an average reflectance being 80% or more for light with a wavelength in a range from 200 nm to 550 nm. The optical thin film having the average reflectance being 80% or more for light with a wavelength in a range from 200 nm to 550 nm reflects the first light having an emission peak wavelength in a range from 200 nm to 550 nm.

When the optical thin film transmitting the second light has a transmittance being 80% or more for light with a wavelength in a range from 700 nm to 1400 nm, the optical thin film transmits the second light having an emission peak wavelength in a range from 800 nm to 1100 nm.

The average reflectance and the transmittance of the optical thin film can be measured using a spectroscopic ellipsometer (e.g., VASE Spectroscopic Ellipsometer, manufactured by J.A.Woollam) by irradiating the light-emitting element with light along a normal direction of the optical thin film (incident angle of 0 degrees).

When the light-emitting device includes the optical thin film, the first light emitted from the light-emitting element is reflected, the light-emitting material of the light-emitting member absorbs and effectively uses the first light, and the second light is emitted from the light-emitting member. The optical thin film is preferably a dielectric multilayer film. The dielectric multilayer film is formed by alternately and periodically layering a first dielectric layer and a second dielectric layer having a refractive index different from that of the first dielectric layer, each with a film thickness of λ/4. λ is a peak wavelength of a wavelength region of light desired to be reflected, and is an in-medium wavelength in the dielectric material. The refractive index of each of the first dielectric layer made of the first dielectric material having a low refractive index and the second dielectric layer made of the second dielectric material having a refractive index higher than that of the first dielectric material , the refractive index difference between the two layers, and the number of cycles in which the layers are alternately formed are appropriately set such that the dielectric multilayer film can stably obtain a desired reflectance in a desired wavelength range.

The refractive index (first refractive index) of the first dielectric layer with a low refractive index can be set in a range from 1.0 to 1.8, for example, and can be preferably set in a range from 1.2 to 1.6. The first dielectric layer, for example, can be formed of SiO₂ (with a refractive index of 1.5, for example). The refractive index (second refractive index) of the second dielectric layer with a high refractive index can be set in a range from 1.5 to 3.0, for example, and can be preferably set in a range from 2.0 to 2.6. The second dielectric layer, for example, can be formed of Nb₂O₅ (with a refractive index of 2.4, for example). The number of cycles in which the first dielectric layer and the second dielectric layer are alternately formed can be set in a range from 1 to 30, for example, and can be preferably set in a range from 1 to 25.

The dielectric material of the first dielectric layer can be selected from, for example, SiO₂, Al₂O₃, and a dielectric material generally called SiAlON. The dielectric material of the second dielectric layer can be composed of a material selected from TiO₂, Nb₂O₅, Ta₂O₅, and Zr₂O₅, for example.

The light-emitting device of the first aspect, the light-emitting device of the second aspect, and the light-emitting device of the third aspect preferably include a light-transmissive member on an emission side of the second light emitted from the light-emitting member. The light-transmissive member is preferably provided with the optical thin film on one of the incident side of the light-transmissive member on which the second light is incident and the emission side of the light-transmissive member from which the second light exits. As the optical thin film, the above-described optical thin film can be used. The light-transmissive member included in the light-emitting device can protect the light-emitting member and the light-emitting element from an external environment. Examples of the material of the light-transmissive member include at least one selected from the group consisting of a resin and a light-transmissive inorganic material. The light-transmissive member has preferably a transmittance being 80% or more for light in a wavelength range of 700 nm or more, more preferably a transmittance being 80% or more for light in a wavelength range from 700 nm to 1100 nm, and still more preferably a transmittance being 80% or more for light in a wavelength range from 700 nm to 1400 nm. The light-transmissive member may be formed having a flat plate shape, and may have a form having a lower surface, an upper surface, and a lateral surface. The resin can be selected from, for example, a silicone resin and an epoxy resin. Examples of the light-transmissive inorganic material include glass materials selected from borosilicate glass and quartz glass, sapphire, BaF₂, and CaF₂.

The light-emitting device of the first aspect, the light-emitting device of the second aspect, and the light-emitting device of the third aspect can be used for a spectroscope. The spectroscope is a device that divides measured light into wavelengths and measures the intensity of each of the wavelengths. The spectroscope includes, for example, an inlet slit, an outlet slit, a diffraction grating, and a mirror associated therewith. The light-emitting device of the first aspect, the light-emitting device of the second aspect, and the light-emitting device of the third aspect can be used as a light source that irradiates a spectroscope with light. For the spectroscope, for example, the spectroscope disclosed in JP 2021-177158 A can be referred to. The light-emitting device of the first aspect, the light-emitting device of the second aspect, and the light-emitting device of the third aspect can be used for a sugar content meter that measures the sugar content of fruits and vegetables. The sugar content meter includes, for example, a light source unit that irradiates an object to be measured with light, a light projecting/receiving unit that projects light to the object to be measured and receives reflected light from the object to be measured, a spectroscopic unit that divides the light received by the light projecting/receiving unit, a photoelectric converter that converts the light subjected to spectroscopic processing by the spectroscopic unit into an electric signal, and a data processing unit that calculates the sugar content based on the electric signal obtained by the conversion. For example, in a fruit or vegetable such as an apple, the absorbance of a wavelength attributed to sugar and the absorbance of a wavelength not attributed to sugar are calculated, and the sugar content of the fruit or vegetable can be measured. The light-emitting device of the first aspect, the light-emitting device of the second aspect, and the light-emitting device of the third aspect can be used as a light source of a sugar content meter. For the sugar content meter, for example, the descriptions of JP 2022-47306 A and JP 09-89767 A can be referred to.

A method for producing a light-emitting member used in a light-emitting device will be described.

A method for producing a light-emitting member used in a light-emitting device includes: mixing a resin, a solvent having a boiling point in a range from 140°C to 300°C, and a light-emitting material that is excited by first light having an emission peak wavelength in a range from 200 nm to 550 nm and emits second light having an emission peak wavelength in a range from 800 nm to 1100 nm to prepare a light-emitting member composition including the light-emitting material in a range from 250 parts by mass to 500 parts by mass with respect to 100 parts by mass of the resin; and curing the light-emitting member composition to form a light-emitting member.

In the method for producing a light-emitting member, because a solvent having a boiling point in a range from 140°C to 300°C is included when the light-emitting member composition is prepared, it is possible to obtain the light-emitting member composition in which the resin and the light-emitting material are substantially uniformly mixed, the light-emitting member composition including the light-emitting material in a range from 250 parts by mass to 500 parts by mass, which is twice or more the amount of the resin, with respect to 100 parts by mass of the resin.

When the light-emitting member composition is prepared, the solvent having a boiling point in a range from 140°C to 300°C preferably includes at least one selected from the group consisting of dodecane, tridecane, tetradecane, pentadecane, and hexadecane. The boiling point of dodecane is in a range from 214°C to 216°C. The boiling point of tridecane is 234°C. The boiling point of tetradecane is in a range from 253°C to 255°C. The boiling point of pentadecane is in a range from 268°C to 270°C. The boiling point of hexadecane is 287°C.

When the light-emitting member composition is prepared, a fluorescent member composition preferably contains a solvent in a range from 0.1 parts by mass to 10 parts by mass with respect to 100 parts by mass of the resin contained in the light-emitting member composition, may contain a solvent in a range from 0.2 parts by mass to 8 parts by mass with respect to 100 parts by mass of the resin, and may contain a solvent in a range from 0.5 parts by mass to 5 parts by mass with respect to 100 parts by mass of the resin. Employing the fluorescent member composition containing the solvent in a range from 0.1 parts by mass to 10 parts by mass with respect to 100 parts by mass of the resin contained in the fluorescent member composition can facilitate uniformly mixing of the resin and the light-emitting material, and can allow the light-emitting member composition to be easily applied to the light-transmissive member or the thin film.

The method for producing a light-emitting member may include preparing a light-emitting member composition in which the resin and the light-emitting material are mixed, the light-emitting member composition including the light-emitting material in a range from 100 parts by mass to 300 parts by mass with respect to 100 parts by mass of the resin.

The method for producing a light-emitting member preferably includes preparing a light-emitting member composition including a phosphor. As the resin and the light-emitting material included in the light-emitting member composition, those same as or similar to the resin and the light-emitting material included in the light-emitting member can be used. As the phosphor, a phosphor same as or similar to the phosphor included in the light-emitting member can be used.

The method for producing a light-emitting member preferably includes applying the light-emitting member composition to a light-transmissive member. As the light-transmissive member in the method for producing a light-emitting member, a light-transmissive member same as or similar to the light-transmissive member used in the light-emitting device can be used. The light-emitting member composition can be applied to a light-transmissive member by a printing method.

The method for producing a light-emitting member may include preparing a light-transmissive member provided with an optical thin film, and applying the light-emitting member composition to either the light-transmissive member or the optical thin film.

The light-transmissive member is formed having a flat plate shape, for example, and the light-transmissive member having a form having a lower surface, an upper surface, and a lateral surface is provided with the optical thin film made of a dielectric multilayer film formed by alternately layering the first dielectric layer and the second dielectric layer having refractive indices different from each other. The dielectric multilayer film can be formed by alternately depositing the first dielectric layer and the second dielectric layer via an atomic layer deposition (ALD) method, sputtering, a vapor deposition method, or the like.

The light-emitting member composition can be applied to either the light-transmissive member or the optical thin film by a printing method. The light-emitting member can be formed by applying the light-emitting member composition, then drying the light-emitting member composition, and curing the resin contained in the light-emitting member composition.

The light-emitting device of the first aspect, the light-emitting device of the second aspect, or the light-emitting device of the third aspect can be produced using the light-emitting member formed as described above. The method for producing a light-emitting device includes a step of preparing a light-emitting member by the producing method described above, a step of disposing a light-transmissive bonding member and a light-emitting element, a step of forming the light-transmissive bonding member, and a step of forming a covering member.

**In** the step of disposing the light-transmissive bonding member and the light-emitting element, a light-transmissive adhesive is applied to one surface of the light-emitting member produced by the method for producing a light-emitting member described above, and the light-emitting element is disposed. In the step of forming the covering member, the covering member is formed so as to embed the light-emitting element and cover a lateral surface of the light-emitting element and a lateral surface of a wavelength conversion member including the light-emitting member.

### EXAMPLES

The present invention will be specifically described hereinafter using examples. However, the present invention is not limited to these examples.

A light-transmissive member, a light-emitting material, an optical thin film, a solvent, and a scattering agent described below were used.

As the light-transmissive member, a glass plate having a thickness of 150 µm was used. For the light-emitting material, the first oxide phosphor having a composition included in the composition formula represented by the formula (I) was used as a first phosphor. The first oxide phosphor had a composition represented by Mg(Ga_{0.955}, Cr_{0.045})₂O₄. The first oxide phosphor was irradiated with light having an emission peak wavelength that is 450 nm, an emission spectrum of the first oxide phosphor at room temperature (about 25°C) was measured, and the emission peak wavelength of the first oxide phosphor was measured from the emission spectrum, by using a quantum efficiency analyzer (QE-2000, manufactured by Otsuka Electronics Co., Ltd). The emission peak wavelength of the first oxide phosphor was 880 nm.

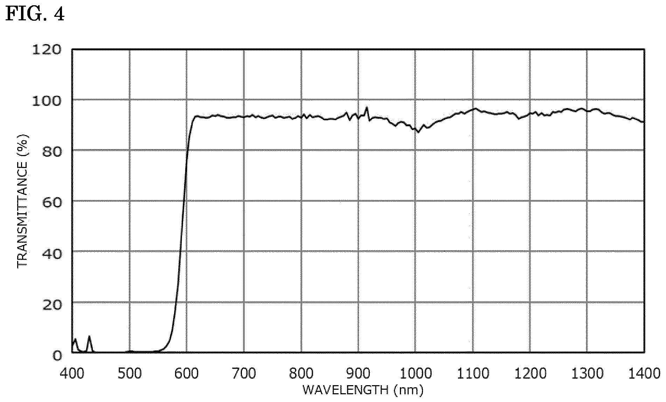

As the optical thin film, a dielectric multilayer film in which a plurality of first dielectric layers using SiO₂ having a refractive index of 1.5 as a first dielectric material and a plurality of second dielectric layers using Nb₂O₅ having a refractive index of 2.4 as a second dielectric material were layered was used. The dielectric multilayer film was irradiated with light along a normal direction (incident angle of 0 degrees) of the dielectric multilayer film, and a transmission spectrum in a wavelength range from 400 nm to 1400 nm was measured at room temperature (25°C ± 5°C) by using the spectroscopic ellipsometer (VASE Spectroscopic Ellipsometer, manufactured by J.A.Woollam). FIG. 4 shows a transmission spectrum of the dielectric multilayer film, which is the optical thin film. In FIG. 4, the vertical axis represents the transmittance (%). The dielectric multilayer film, which is the optical thin film, had a transmittance of the optical thin film being 80% or more for light with a wavelength in a range from 700 nm to 1400 nm, and transmitted the second light having an emission peak wavelength in a range from 800 nm to 1100 nm. The reflectance for the first light emitted from the light-emitting element having an emission peak wavelength of 450 nm used in the light-emitting device described later was almost 100% at 450 nm, which is the emission peak wavelength of the light-emitting element.

As the solvent, tridecane (boiling point is 234°C) was used.

As the scattering agent, aluminum oxide was used.

### FIRST EXAMPLE

The light-emitting device of the first aspect or the third aspect was produced as the light-emitting device of Example 1. For the light-emitting device, FIG. 1 can be referred to. For the members of the light-emitting device, reference characters in FIG. 1 can be referred to.

The light-emitting element 10 was used in which nitride-based semiconductor layers with an emission peak wavelength of 450 nm were layered. The light-emitting element 10 has a substantially square planar shape with a size of about 1.00 mm square, and has a thickness of about 0.15 mm.

A light-emitting member composition used in the light-emitting device was prepared. When the light-emitting member composition was prepared, a silicone resin, aluminum oxide as a filler, and the first oxide phosphor having the above-described composition as the light-emitting material were used.

When the light-emitting member composition was prepared, 280 parts by mass of the first oxide phosphor as the light-emitting material 21 with respect to 100 parts by mass of the silicone resin and 1.25 mass% of aluminum oxide as the scattering agent with respect to the total amount of the light-emitting member composition were mixed to prepare the light-emitting member composition.

When the light-emitting member was formed, the dielectric multilayer film described above was formed, as the optical thin film 30, on the light-transmissive member 40 described above, the light-emitting member composition was applied onto the optical thin film 30 by a printing method, and the resin 22 was cured to form the light-emitting member 20 having a thickness of 67 µm. The light-emitting member 20 includes the light-emitting material 21 and the resin 22. The light-transmissive member 40, the optical thin film 30, and the light-emitting member 20 were layered in this order to configure the wavelength conversion member 50.

The light-emitting device 100 was produced using the wavelength conversion member 50 including the light-emitting member 20 that was formed.

**In** a step of disposing the light-emitting element, a ceramic substrate made of aluminum nitride as a material was used as a substrate. As the light-emitting element, a light-emitting element in which nitride-based semiconductor layers having an emission peak wavelength of 450 nm were layered was used. The light-emitting element has a substantially square planar shape with a size of about 1.0 mm square, and has a thickness of about 0.11 mm. The light-emitting element was disposed such that the light emission surface was on the substrate side, and flip-chip mounted with a bump using a conductive member made of Au. The semiconductor element was flip-chip mounted with the bump using the conductive member made of Au at an interval from the light-emitting element.

In a step of bonding the light-emitting element and the wavelength conversion member, one surface of the wavelength conversion member having a substantially square planar shape of about 1.15 mm square and one surface of the light-emitting element having a substantially square planar shape of about 1.0 mm square were bonded using an adhesive including a silicone resin to form an adhesive layer between the light-emitting element and the wavelength conversion member.

A silicone resin that is a light-transmissive adhesive was applied to one surface of the produced light-emitting member 20, and the light-emitting element 10 was disposed. The adhesive protruded from a portion between the light-emitting element 10 and the light-emitting member 20 was extended from the lateral surface of the light-emitting element 10 to the periphery of the light-emitting member 20 and adhered, and cured into a fillet shape to form the light-transmissive bonding member 70.

In a step of forming the covering member, a covering member composition including a silicone resin and titanium oxide particles and including 60 parts by mass of the titanium oxide particles with respect to 100 parts by mass of the silicone resin was prepared. Lateral surface of the light-emitting element 10 disposed on the substrate and lateral surface of a wavelength conversion body including the light-emitting member 20 and the light-transmissive member 40 were covered with the covering member composition, the covering member composition supplied such that the semiconductor element was completely embedded in the covering member composition, the covering member composition was cured to form the covering member, and thus a resin package was formed, whereby the light-emitting device 100 was produced.

### SECOND EXAMPLE

When the light-emitting member composition was prepared, 228 parts by mass of the first oxide phosphor as the light-emitting material 21 with respect to 100 parts by mass of the silicone resin and 1.25 mass% of aluminum oxide as the scattering agent with respect to the total amount of the light-emitting member composition were mixed to prepare the light-emitting member composition. The light-emitting device was produced as in Example 1 except that this light-emitting member composition was prepared.

### THIRD EXAMPLE

When the light-emitting member composition was prepared, 150 parts by mass of the first oxide phosphor as the light-emitting material 21 with respect to 100 parts by mass of the silicone resin and 1.25 mass% of aluminum oxide as the scattering agent with respect to the total amount of the light-emitting member composition were mixed to prepare the light-emitting member composition. The light-emitting device was produced as in Example 1 except that this light-emitting member composition was prepared.

### FOURTH EXAMPLE

The light-emitting device of the second aspect or the third aspect was produced. For the light-emitting device, FIG. 3 can be referred to. For the members of the light-emitting device, reference characters in FIG. 3 can be referred to.

When a light-emitting member composition was prepared, the light-emitting member composition including 400 parts by mass of the first oxide phosphor as the light-emitting material 21 and 5 parts by mass of tridecane as the solvent with respect to 100 parts by mass of the silicone resin, and including 1.25 mass% of aluminum oxide as the scattering agent with respect to the total amount of the light-emitting member composition was prepared.

When the light-emitting member was formed, the light-emitting member composition was applied to the above-described light-transmissive member 40 not provided with an optical thin film by a printing method and a resin was cured; thus, the light-emitting member 20 having a thickness of 71 µm was formed. The light-emitting member 20 includes the light-emitting material 21 and the resin 22. The light-transmissive member 40 and the light-emitting member 20 were layered in this order to obtain the wavelength conversion member 50.

The light-emitting device 200 was produced as in Example 1 except that the light-emitting member composition and the wavelength conversion member 50 that are described above were used.

### FIFTH EXAMPLE

When a light-emitting member composition was prepared, 280 parts by mass of the first oxide phosphor as the light-emitting material 21 with respect to 100 parts by mass of the silicone resin and 5.00 mass% of aluminum oxide with respect to the total amount of the light-emitting member composition were mixed to prepare the light-emitting member composition.

The light-emitting device was produced as in Example 4 except that the above-described light-emitting member composition was used.

### SIXTH EXAMPLE

When a light-emitting member composition was prepared, 280 parts by mass of the first oxide phosphor as the light-emitting material 21 with respect to 100 parts by mass of the silicone resin and 1.25 mass% of aluminum oxide as the scattering agent with respect to the total amount of the light-emitting member composition were mixed to prepare the light-emitting member composition.

The light-emitting device was produced as in Example 4 except that the above-described light-emitting member composition was used.

### FIRST COMPARATIVE EXAMPLE

When a light-emitting member composition was prepared, 150 parts by mass of the first oxide phosphor as the light-emitting material 21 with respect to 100 parts by mass of the silicone resin and 1.25 mass% of aluminum oxide with respect to the total amount of the light-emitting member composition were mixed to prepare the light-emitting member composition.

The light-emitting device was produced as in Example 4 except that the above-described light-emitting member composition was used.

### SECOND COMPARATIVE EXAMPLE

When a light-emitting member composition was prepared, 228 parts by mass of the first oxide phosphor as the light-emitting material 21 with respect to 100 parts by mass of the silicone resin and 1.25 mass% of aluminum oxide with respect to the total amount of the light-emitting member composition were mixed to prepare the light-emitting member composition.

The light-emitting device was produced as in Example 4 except that the above-described light-emitting member composition was used.

Table 1 shows the light-emitting material content, the solvent content, and the scattering agent content in the light-emitting member composition and the presence or absence of the optical thin film in each of the light-emitting devices of Examples and Comparative Examples. In Table 1, the light-emitting material content and the solvent content are the content (parts by mass) of the light-emitting material or the content (parts by mass) of the solvent with respect to 100 parts by mass of the resin included in the light-emitting member composition. The scattering agent content is the content (mass%) of the scattering agent with respect to 100 mass% of the total amount of the light-emitting member composition or the light-emitting member.

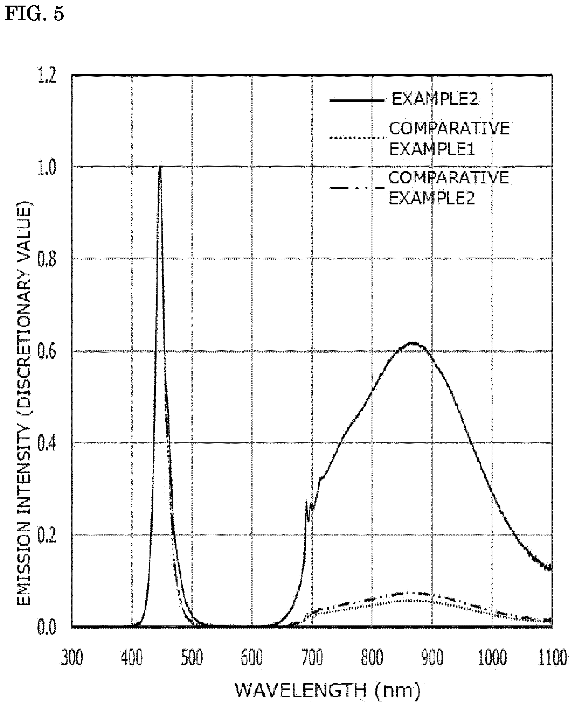

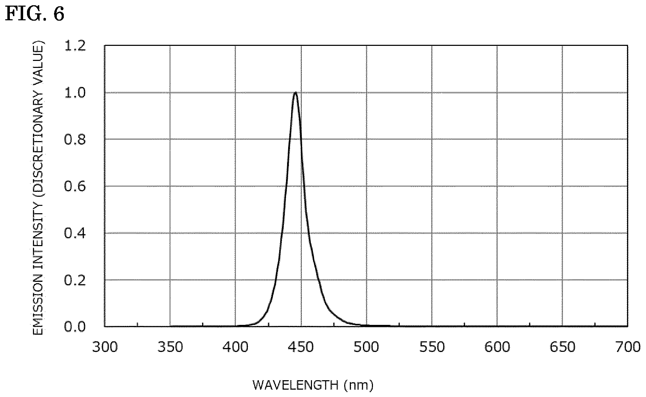

For each light-emitting device and the light-emitting element used in each light-emitting device, the emission spectrum of each light-emitting device and the emission spectrum of the light-emitting element were measured using a light measurement system in which a spectrophotometer (PMA-12, manufactured by Hamamatsu Photonics K.K) and an integrating sphere were combined. The emission spectrum of each light-emitting device and the emission spectrum of the light-emitting element were measured at room temperature (20°C to 30°C). FIG. 5 shows the emission spectrum of each of the light-emitting devices according to Example 2 and Comparative Examples 1 and 2. FIG. 6 shows the emission spectrum of the light-emitting element used in each light-emitting device. In the emission spectrum of each light-emitting device, the first integrated value ratio Ib/Ia of the integrated value Ib of the emission intensity at a wavelength in a range from 550 nm to 600 nm with respect to the integrated value Ia of the emission intensity at a wavelength in a range from 200 nm to less than 550 nm and the second integrated value ratio Ic/Ia that is the integrated value Ic of the emission intensity at a wavelength in a range from 800 nm to 1100 nm with respect to the integrated value Ia were calculated. The third integrated value ratio Ic/Ia' that is the integrated value Ic of the emission intensity at a wavelength in a range from 800 nm to 1100 nm in the emission spectrum of each light-emitting device with respect to the integrated value Ia' of the emission intensity at a wavelength in a range from 200 nm to less than 550 nm in the emission spectrum of the light-emitting element was calculated. With the integrated value of a radiant flux in a range from 800 nm to 1100 nm of the emission spectrum of the light-emitting device of Comparative Example 1 being 100%, the integrated value of a radiant flux in a range from 800 nm to 1100 nm in the emission spectrum of each of the light-emitting devices of Examples and Comparative Example 2 was measured as a relative radiant flux. The results are shown in Table 1.

**[Table 1]**

| | 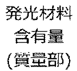 | 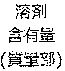 | 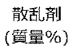 | 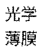 | 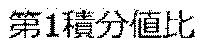 (Ib/Ia) | 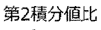 (Ic/Ia) | 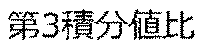 (Ic/Ia') | 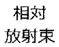 (%) |
|---|---|---|---|---|---|---|---|---|
| 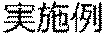 1 | 280 | 0 | 1.25 | 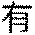 | 0.004 | 5.59 | 0.154 | 125.0 |
| 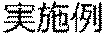 2 | 228 | 0 | 1.25 | 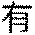 | 0.003 | 4.75 | 0.156 | 126.2 |
| 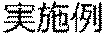 3 | 150 | 0 | 1.25 | 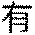 | 0.003 | 3.65 | 0.151 | 122.0 |
| 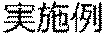 4 | 400 | 5 | 1.25 | 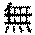 | 0.003 | 1.23 | 0.142 | 115.4 |
| 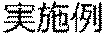 5 | 280 | 0 | 5.00 | 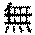 | 0.003 | 1.09 | 0.134 | 108.9 |
| 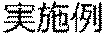 6 | 280 | 0 | 1.25 | 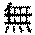 | 0.003 | 0.85 | 0.136 | 110.5 |
| 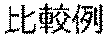 1 | 150 | 0 | 1.25 | 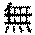 | 0.002 | 0.49 | 0.123 | 100.0 |
| 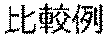 2 | 228 | 0 | 1.25 | 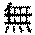 | 0.002 | 0.62 | 0.129 | 105.2 |

For the light-emitting devices according to Examples 1 to 6, the relative radiant fluxes were larger than those of Comparative Examples 1 and 2.

For the light-emitting devices according to Examples 1 to 3, in the emission spectra of the light-emitting devices, the first integrated value ratio Ib/Ia was in a range from 0 to 0.05, and the second integrated value ratio Ic/Ia was in a range from 0.75 to 30. For the light-emitting devices according to Examples 1 to 3, the third integrated value ratio Ic/Ia' was 0.13 or more. The light-emitting devices according to Examples 1 to 3 include the optical thin film by which the first light emitted from the light-emitting element is reflected, at least part of the first light is absorbed and effectively used by the light-emitting material in the light-emitting member, and the second light is emitted from the light-emitting member. Therefore, light in which the first integrated value ratio Ib/Ia was in a range from 0 to 0.05, the second integrated value ratio Ic/Ia was in a range from 0.75 to 30, and the third integrated value ratio Ic/Ia' was 0.13 or more was emitted from the light-emitting devices.

Because in the light-emitting devices according to Examples 4 to 6, even when the optical thin film is not included in the light-emitting member, the light-emitting member composition used in the light-emitting member includes the solvent and/or the scattering agent, even when the amount of the light-emitting material was as much as in a range from 250 parts by mass to 500 parts by mass with respect to 100 parts by mass of the resin, the resin and the light-emitting material were substantially uniformly mixed, and it became easy to uniformly apply the light-emitting member composition to the light-transmissive member. The light-emitting device according to Examples 4 to 6 include the light-emitting member made from the above-described light-emitting member composition. The light-emitting member includes the light-emitting material in a range from 250 parts by mass to 500 parts by mass with respect to 100 parts by mass of the resin. Due to this, the light-emitting material effectively used the first light emitted from the light-emitting element and emitted the second light, and the light-emitting device emitted light in which the first integrated value ratio Ib/Ia was in a range from 0 to 0.05, the second integrated value ratio Ic/Ia was in a range from 0.75 to 30, and the third integrated value ratio Ic/Ia' was 0.13 or more.

Because in the light-emitting devices according to Comparative Examples 1 and 2, the light-emitting member does not include the optical thin film and the light-emitting member composition includes less than 250 parts by mass of the light-emitting material with respect to 100 parts by mass of the resin, the first light emitted from the light-emitting element was not effectively used by the light-emitting material, and the second integrated value ratio Ic/Ia was less than 0.75. In the light-emitting devices according to Comparative Examples 1 and 2, the first light emitted from the light-emitting element was not effectively used by the light-emitting material, and the third integrated value ratio Ic/Ia' that is the integrated value Ic of the emission intensity at a wavelength in a range from 800 nm to 1100 nm in the emission spectrum of the light-emitting device with respect to the integrated value Ia' of the emission intensity at a wavelength in the range from 200 nm to less than 550 nm in the emission spectrum of the light-emitting element was 0.13 or less.

FIG. 5 is a graph showing the emission spectra of the light-emitting devices of Example and Comparative Examples. The emission spectra in FIG. 5 indicate the emission intensity with respect to the emission wavelength using the emission intensity at the emission peak wavelength of the light-emitting element as 1 (reference). As shown in FIG. 5, in the emission spectrum of the light-emitting device according to Example 2, the emission intensity at a wavelength in a range from 800 nm to 1100 nm was higher than the emission intensity at a wavelength in a range from 800 nm to 1100 nm in the emission spectrum of each of the light-emitting devices according to Comparative Examples 1 and 2. As in the light-emitting device according to Example 2, it is presumable that in each of the light-emitting devices of Examples 1 to 6, the first light emitted from the light-emitting element was effectively used by the light-emitting material, and the emission intensity of the second light having an emission peak wavelength in a range from 800 nm to 110 nm became high. FIG. 6 is a graph showing the emission spectrum of the light-emitting element used in each of the light-emitting devices of Examples and Comparative Examples. The integrated value Ia' of the emission intensity at a wavelength in a range from 200 nm to less than 550 nm in the emission spectrum of the light-emitting element can be calculated from the emission spectrum of the light-emitting element.

### Industrial Applicability

The light-emitting device according to the present disclosure can be used for a medical analytical instrument for obtaining information in a living body, a measurement instrument mounted on a small mobile device such as a smartphone for physical condition management or the like, a spectroscope that non-destructively measures information inside foods such as fruits, vegetables and rice, a sugar content meter, a reflection spectroscopic measurement device used for measurement of a film thickness or the like, and a detection device for improper additives, bulking materials, moisture, or the like of meat.

### Reference Signs List

10: Light-emitting element, 11p, 11n: Electrode, 20: Light-emitting member, 21: Light-emitting material, 22: Resin, 30: Optical thin film, 40: Light-transmissive member, 50: Wavelength conversion member, 60: Covering member, 70: Light-transmissive bonding member, 100, 200: Light-emitting device.

## Claims

1. A light-emitting device comprising:
a light-emitting element configured to emit first light having an emission peak wavelength in a range from 200 nm to 550 nm;
a light-emitting member comprising a resin and a light-emitting material disposed on a light emission side of the light-emitting element and configured to absorb and emit at least part of the first light, the light-emitting material being configured to emit second light having an emission peak wavelength in a range from 780 nm to 1100 nm; and
an optical thin film disposed on a light emission side of the light-emitting member and configured to reflect the first light and transmit the second light, wherein
in an emission spectrum of a light-emitting device, a first integrated value ratio Ib/Ia of an integrated value Ib of emission intensity at a wavelength in a range from 550 nm to 600 nm with respect to an integrated value Ia of emission intensity at a wavelength in a range from 200 nm to less than 550 nm is in a range from 0 to 0.05, and a second integrated value ratio Ic/Ia that is an integrated value Ic of emission intensity at a wavelength in a range from 800 nm to 1100 nm with respect to the integrated value Ia is in a range from 0.75 to 30.

2. The light-emitting device according to claim 1, further comprising:
a light-transmissive member on the emission side from which the second light exits, wherein
the optical thin film is provided on one of an incident side of the light-transmissive member on which the second light is incident and an emission side of the light-transmissive member from which the second light exits.

3. The light-emitting device according to claim 1 or 2, wherein the optical thin film is a dielectric multilayer film.

4. The light-emitting device according to any one of claims 1 to 3, wherein the light-emitting material comprises a phosphor.

5. The light-emitting device according to claim 4, wherein the phosphor comprises an oxide phosphor having a composition comprised in a composition formula represented by a following formula (I).
(Mg_{1 - t1}M¹ₜ₁)ᵤ₁(Ga_{1 - v1 - x1 - y1}M²ᵥ₁)₂O_{w1}:Crₓ₁, M³_{y1} (I)
(In the formula (I), M¹ is at least one element selected from the group consisting of Ca, Sr, Ba, Ni, and Zn, M² is at least one element selected from the group consisting of B, Al, In, and Sc, M³ is at least one element selected from the group consisting of Eu, Ce, Tb, Pr, Nd, Sm, Yb, Ho, Er, Tm, and Mn, and t1, u1, v1, w1, x1, and y1 satisfy 0 ≤ t1 ≤ 0.8, 0.7 ≤ u1 ≤ 1.3, 0 ≤ v1 ≤ 0.8, 3.7 ≤ w1 ≤ 4.3, 0.02 < x1 ≤ 0.3, 0 ≤ y1 ≤ 0.2, and y1 < x1.)

6. A light-emitting device comprising:
a light-emitting element configured to emit first light having an emission peak wavelength in a range from 200 nm to 550 nm; and
a light-emitting member disposed on a light emission side of the light-emitting element and comprising a resin and a light-emitting material, wherein
the light-emitting material is configured to absorb at least part of the first light and
configured to emit second light having an emission peak wavelength in a range from 780 nm to 1100 nm,
the light-emitting member contains the light-emitting material in a range from 250 parts by mass to 500 parts by mass with respect to 100 parts by mass of the resin, and
in an emission spectrum of the light-emitting device, a first integrated value ratio Ib/la that is an integrated value Ib of emission intensity at a wavelength in a range from 550 nm to 600 nm with respect to an integrated value Ia of emission intensity at a wavelength in a range from 200 nm to less than 550 nm is in a range from 0 to 0.05, and a second integrated value ratio Ic/Ia that is an integrated value Ic of emission intensity at a wavelength in a range from 800 nm to 1100 nm with respect to the integrated value Ia is in a range from 0.75 to 30.

7. The light-emitting device according to claim 6, wherein the light-emitting member comprises a scattering agent in a range from 1.0 mass% to 5.0 mass% with respect to a total amount of the light-emitting member.

8. The light-emitting device according to claim 6 or 7, further comprising an optical thin film disposed on a light emission side of the light-emitting member and configured to reflect the first light and transmit the second light.

9. The light-emitting device according to any one of claims 6 to 8, comprising a light-transmissive member on an emission side from which the second light exits.

10. The light-emitting device according to claim 8 or 9, wherein the optical thin film is a dielectric multilayer film.

11. The light-emitting device according to any one of claims 6 to 10, wherein the light-emitting material comprises a phosphor.

12. The light-emitting device according to claim 11, wherein the phosphor comprises an oxide phosphor having a composition comprised in a composition formula represented by a following formula (I).
(Mg_{1 - t1}M¹ₜᵢ)ᵤ₁(Ga_{1 - v1 - x1 - y1}M²ᵥ₁)₂O_{w1}:Crₓ₁, M³_{y1} (I)
(In the formula (I), M¹ is at least one element selected from the group consisting of Ca, Sr, Ba, Ni, and Zn, M² is at least one element selected from the group consisting of B, Al, In, and Sc, M³ is at least one element selected from the group consisting of Eu, Ce, Tb, Pr, Nd, Sm, Yb, Ho, Er, Tm, and Mn, and t1, u1, v1, w1, x1, and y1 satisfy 0 ≤ t1 ≤ 0.8, 0.7 ≤ u1 ≤ 1.3, 0 ≤ v1 ≤ 0.8, 3.7 ≤ w1 ≤ 4.3, 0.02 < x1 ≤ 0.3, 0 ≤ y1 ≤ 0.2, and y1 < x1.)

13. A light-emitting device comprising:
a light-emitting element configured to emit first light having an emission peak wavelength in a range from 200 nm to 550 nm; and
a light-emitting member disposed on a light emission side of the light-emitting element and comprising a resin and a light-emitting material, wherein,
the light-emitting material is configured to absorb at least part of the first light and
configured to emit second light having an emission peak wavelength in a range from 780 nm to 1100 nm, and
in an emission spectrum of the light-emitting element, a third integrated value ratio Ic/Ia' that is an integrated value Ic of emission intensity at a wavelength in a range from 800 nm to 1100 nm in an emission spectrum of the light-emitting device with respect to an integrated value Ia' of emission intensity at a wavelength in a range from 200 nm to less than 550 nm is 0.13 or more.

14. The light-emitting device according to claim 13, further comprising an optical thin film disposed on a light emission side of the light-emitting member and configured to reflect the first light and transmit the second light.

15. The light-emitting device according to claim 13 or 14, wherein the light-emitting member comprises the light-emitting material in a range from 250 parts by mass to 500 parts by mass with respect to 100 parts by mass of the resin.

16. The light-emitting device according to any one of claims 13 to 15, wherein the light-emitting member comprises a scattering agent in a range from 1.0 mass% to 5.0 mass% with respect to a total amount of the light-emitting member.

17. The light-emitting device according to any one of claims 13 to 16, further comprising a light-transmissive member on an emission side from which the second light exits.

18. The light-emitting device according to claim 14, wherein the optical thin film is a dielectric multilayer film.

19. The light-emitting device according to any one of claims 13 to 18, wherein the light-emitting material comprises a phosphor.

20. The light-emitting device according to any one of claims 13 to 19, wherein the phosphor comprises an oxide phosphor having a composition comprised in a composition formula represented by a following formula (I).
(Mg_{1 - t1}M¹ₜ₁)ᵤ₁(Ga_{1 - v1 - x1 - y1}M²ᵥ₁)₂O_{w1}:Crₓ₁, M³_{y1} (I)
(In the formula (I), M¹ is at least one element selected from the group consisting of Ca, Sr, Ba, Ni, and Zn, M² is at least one element selected from the group consisting of B, Al, In, and Sc, M³ is at least one element selected from the group consisting of Eu, Ce, Tb, Pr, Nd, Sm, Yb, Ho, Er, Tm, and Mn, and t1, u1, v1, w1, x1, and y1 satisfy 0 ≤ t1 ≤ 0.8, 0.7 ≤ u1 ≤ 1.3, 0 ≤ v1 ≤ 0.8, 3.7 ≤ w1 ≤ 4.3, 0.02 < x1 ≤ 0.3, 0 ≤ y1 ≤ 0.2, and y1 < x1.)

21. A spectroscope comprising the light-emitting device according to any one of claims 1 to 20.

22. A producing method for a light-emitting member, the method comprising:
mixing a resin, a solvent having a boiling point in a range from 140°C to 300°C, and a light-emitting material that absorbs at least part of first light having an emission peak wavelength in a range from 200 nm to 550 nm and emits second light having an emission peak wavelength in a range from 800 nm to 1100 nm to prepare a light-emitting member composition comprising the light-emitting material in a range from 250 parts by mass to 500 parts by mass with respect to 100 parts by mass of the resin; and
curing the light-emitting member composition to form a light-emitting member.

23. The producing method according to claim 22, further comprising applying the light-emitting member composition to a light-transmissive member.

24. The producing method according to claim 22, further comprising:
preparing a light-transmissive member provided with an optical thin film; and
applying the light-emitting member composition to either the light-transmissive member or the optical thin film.

25. The producing method according to any one of claims 22 to 24, wherein the light-emitting material comprises a phosphor when the light-emitting member composition is prepared.

26. The producing method according to any one of claims 22 to 25, wherein when the light-emitting member composition is prepared, the solvent comprises at least one selected from the group consisting of dodecane, tridecane, tetradecane, pentadecane, and hexadecane.
